(19) Europäisches Patentamt
European Patent Office
Office européen des brevets

(11) EP 3 376 613 A1

(12) DEMANDE DE BREVET EUROPEEN

(43) Date de publication:
19.09.2018 Bulletin 2018/38

(51) Int Cl.:
H01S 5/00 (2006.01)          F21S 41/64 (2018.01)
F21V 14/04 (2006.01)

(21) Numéro de dépôt: 18160238.4

(22) Date de dépôt: 06.03.2018

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 15.03.2017 FR 1752123

(71) Demandeur: Valeo Vision
93012 Bobigny Cedex (FR)

(72) Inventeur: ALBOU, Pierre
93012 BOBIGNY Cedex (FR)

(74) Mandataire: Valeo Vision
IP Department
34, rue Saint André
93012 Bobigny (FR)

(54) DISPOSITIF LUMINEUX AVEC MOYEN MOBILE DE BALAYAGE ET FIBRE OPTIQUE

(57) L'invention concerne un dispositif lumineux, notamment pour véhicule automobile comprenant :
- au moins une source lumineuse (301) laser émettant un faisceau lumineux laser;
- un matériau de conversion de longueur d'onde (309) apte à convertir une partie d'un faisceau lumineux laser, à diffuser une autre partie du faisceau lumineux laser et à combiner les parties diffusée et convertie en un faisceau lumineux primaire résultant ;
- un moyen mobile de balayage (308) du faisceau lumineux laser sur le matériau de conversion de longueur d'onde ;
- un moyen optique de projection (310) du faisceau lumineux primaire;
- une fibre optique (306) agencée pour recevoir sur une face d'entrée le faisceau lumineux laser émis par la source lumineuse laser et pour diriger ledit faisceau lumineux laser vers le moyen mobile de balayage (308).

FIG. 2

## Description

La présente invention concerne le domaine des dispositifs lumineux pour véhicule automobile. Plus particulièrement, l'invention concerne un dispositif lumineux pour véhicule automobile.

Un véhicule automobile comprend généralement plusieurs dispositifs lumineux constituant des moyens d'éclairage ou de signalisation ou d'éclairage de l'intérieur de l'habitacle remplissant des fonctions diverses. Ces fonctions sont notamment remplies grâce à l'émission d'un faisceau lumineux dont les propriétés varient d'une fonction à l'autre.

Lorsque le faisceau lumineux doit présenter une forte intensité lumineuse, il est connu d'utiliser une source de lumière de haute luminance, par exemple un laser. Il est alors souhaitable, d'une part, de modifier le spectre lumineux de ce faisceau par des moyens de conversion de longueur d'onde connus en soi, et, d'autre part, de focaliser ce faisceau de manière à former un spot lumineux de forme prédéterminée sur une cible formée par lesdits moyens de conversion. Dans ce cadre, le dispositif peut intégrer un moyen mobile de balayage formé par un ou plusieurs micro-miroirs destiné à balayer un faisceau lumineux passant par ledit moyen mobile de balayage et formant une tache lumineuse sur les moyens de conversion de longueur d'onde, afin de réaliser un faisceau lumineux sortant du feu après projection par un moyen de projection ayant la forme souhaitée. Or, ces différents moyens sont soumis à des contraintes d'encombrement, notamment à l'avant du véhicule automobile. En effet, la partie avant d'un véhicule automobile comprend de nombreux éléments dont il convient de limiter au maximum l'encombrement.

Dans un tel moyen mobile de balayage, la forme et la taille du spot sur le matériau de conversion de longueur d'onde dépendent de la géométrie du système. Plus particulièrement, elles dépendent des dimensions du moyen mobile de balayage et de sa distance par rapport au matériau de conversion de longueur d'onde et à la source lumineuse. Dans le but d'obtenir un spot rectangulaire sur le matériau de conversion de longueur d'onde, une optique anamorphique peut être utilisée. Il est alors préférable d'orienter la source lumineuse et l'optique associée pour orienter le spot rectangulaire sur le matériau de conversion de longueur d'onde.

Certaines solutions de l'état de la technique préconisent, pour obtenir des performances améliorées en éclairage automobile, plus particulièrement pour réaliser des fonctions d'éclairage de type route sans multiplier les modules, d'utiliser plusieurs sources lumineuses par moyen mobile de balayage. Pour cela, différents procédés sont envisageables, notamment l'utilisation d'un séparateur polarisant, connu en anglais sous le nom de «polarizing beam splitter » (PBS). Les séparateurs polarisants sont utilisés pour diviser le faisceau non polarisé en deux parties polarisées. Dans ce cas, et sauf utilisation éventuelle d'une lame demi-onde onéreuse, les deux spots superposés finalement créés dans le plan du matériau de conversion sont orientés à 90 degrés formant un spot en forme de signe plus, également appelée forme de « drapeau suisse ». Une lame demi-onde désigne un outil optique capable de modifier la polarisation du faisceau lumineux la traversant.

Il est possible que le faisceau lumineux présente des coupures et, afin d'améliorer la qualité des coupures du faisceau lumineux, le spot peut prendre une orientation privilégiée lorsqu'il est allongé : un spot en forme de signe plus est assez peu avantageux de ce point de vue.

En outre, tout changement de moyen mobile de balayage ou de source lumineuse implique une reconception de l'optique de focalisation et de la mécanique de fixation, notamment dans le cas d'un changement de source lumineuse. Enfin, le dispositif obtenu est assez encombrant car il comprend plusieurs sources lumineuses, plusieurs optiques de focalisation, des coupleurs et plusieurs moyens mobiles de balayage, en arrière ou aux alentours de l'objectif de projection.

La présente invention vient améliorer la situation.

Un premier aspect de l'invention concerne un dispositif lumineux, notamment pour véhicule automobile comprenant :

- au moins une source lumineuse laser émettant un faisceau lumineux laser;
- un matériau de conversion de longueur d'onde apte à convertir une partie d'un faisceau lumineux laser, à diffuser une autre partie du faisceau lumineux laser et à combiner les parties diffusée et convertie en un faisceau lumineux primaire résultant ;
- un moyen mobile de balayage du faisceau lumineux laser sur le matériau de conversion de longueur d'onde ;
- un moyen optique de projection du faisceau lumineux primaire ;
- une fibre optique agencée pour recevoir sur une face d'entrée le faisceau lumineux laser émis par la source lumineuse laser et pour diriger ledit faisceau lumineux laser vers le moyen de balayage.

Ainsi, l'utilisation d'une fibre optique permet de découpler les contraintes qui s'appliquent d'une part à la source, et d'autre part, à la partie du dispositif comprenant le moyen mobile de balayage et le moyen de conversion. Il est ainsi plus aisé de respecter des contraintes géométriques prédéfinies, telles que les contraintes géométriques évoquées en partie introductive.

En complément, le matériau de conversion de longueur d'onde peut être est une plaque de matériau photoluminescent.

Le matériau photoluminescent peut notamment être choisi en fonction de la longueur d'onde de la source lumineuse laser de manière à augmenter l'efficacité de la conversion et de réduire les pertes lumineuses.

Selon un mode de réalisation, la source lumineuse laser peut être une diode laser comprenant une face d'émission perpendiculaire à un axe optique d'émission.

Selon un mode de réalisation, la fibre optique peut être une fibre optique multimodes.

Ainsi, le faisceau lumineux laser peut entrer dans la fibre selon plusieurs angles d'entrée possibles. En outre, une telle fibre multimode est avantageuse dans le cas de trajets courts.

Selon un mode de réalisation, la fibre optique peut être définie par au moins un diamètre de coeur et une ouverture numérique, et, le diamètre de coeur, l'ouverture numérique et l'agencement de la fibre optique relativement au moyen de balayage sont tels que le faisceau balayé forme une tâche d'au plus 300 micromètres sur le moyen de conversion.

Ainsi, la résolution du balayage du faisceau lumineux laser sur le matériau de conversion de longueur d'onde n'est que peu impactée par l'introduction de la fibre optique.

En complément, le diamètre de coeur, l'ouverture numérique et l'agencement de la fibre optique relativement au moyen mobile de balayage peuvent être tels que le faisceau balayé forme une tâche d'au plus 250 micromètres sur le moyen de conversion.

Ainsi, la résolution du balayage du faisceau lumineux laser sur le matériau de conversion de longueur d'onde n'est pas impactée par l'introduction de la fibre optique.

Selon un mode de réalisation, le dispositif lumineux peut comprendre un moyen de focalisation ou un moyen d'anamorphose disposé entre la sortie de la fibre optique et le moyen mobile de balayage.

Ainsi, il est possible d'obtenir des grandissements différents de la source du faisceau incident selon des directions de modification de divergence du moyen d'anamorphose ou du moyen de focalisation.

Selon un mode de réalisation, le dispositif lumineux peut comprendre un moyen d'anamorphose primaire disposé entre chaque source lumineuse et la face d'entrée de la fibre optique.

Ainsi, il est possible de contrôler la taille de l'image formée de la source lumineuse au niveau de la face d'entrée de la fibre optique et l'ouverture numérique du faisceau incident.

En complément, le moyen d'anamorphose primaire peut être agencé de manière à former une image du faisceau lumineux émis, sur la fibre optique, ladite image ayant des dimensions inférieures ou égales à la face d'entrée de la fibre optique et l'ouverture numérique du faisceau incident étant inférieure ou égale à celle de la fibre optique.

Ainsi, la perte de puissance au niveau de la face d'entrée de la fibre optique est limitée ou évitée.

En complément, le moyen d'anamorphose primaire peut comprendre au moins deux lentilles.

En complément, chaque lentille peut être agencée de manière à modifier la divergence d'un faisceau incident selon une direction de traitement donnée pour obtenir un grandissement prédéterminé selon la direction de traitement donnée

Ainsi, le moyen d'anamorphose primaire comportant deux lentilles permet de contrôler le grandissement obtenu selon une direction de traitement donnée pour le faisceau incident au niveau de la face d'entrée de la fibre optique, permettant ainsi d'optimiser la taille de l'image formée sur la face d'entrée de la fibre optique.

En complément, les directions de traitement des lentilles du moyen d'anamorphose sont perpendiculaires entre elles.

En complément, les grandissements des lentilles du moyen d'anamorphose primaire peuvent être distincts.

Ainsi, il est possible d'obtenir des images du faisceau lumineux incident de tailles différentes au niveau de la face d'entrée de la fibre optique.

De manière alternative, les lentilles du moyen d'anamorphose primaire peuvent être des lentilles cylindriques ayant des génératrices respectives s'étendant dans des plans perpendiculaires entre eux.

Selon un mode de réalisation, le dispositif lumineux peut comprendre une source lumineuse primaire émettant un premier faisceau lumineux et une source lumineuse secondaire émettant un second faisceau lumineux, et la fibre optique peut être agencée pour recevoir sur la face d'entrée les premier et second faisceaux lumineux laser de manière à diriger lesdits premier et second faisceaux lumineux laser vers le moyen de balayage.

Ainsi, l'utilisation de deux sources lumineuses laser permet d'augmenter la puissance du faisceau lumineux laser incident.

De manière alternative, les sources lumineuses primaire et secondaire peuvent être agencées de manière à émettre des faisceaux lumineux laser polarisés dans des plans respectifs perpendiculaires entre eux. Les divergences maximum et minimum du faisceau d'une diode laser sont situées dans deux plans perpendiculaires qui sont parallèles aux côtés de la facette de sortie. En prenant en compte ces deux plans, à l'aide de lentilles cylindriques, les axes de celles-ci sont alors parallèles à l'un ou l'autre de ces plans et perpendiculaires à l'axe d'émission.

En complément, le dispositif lumineux peut comporter un moyen de combinaison apte à combiner les faisceaux laser en provenance des sources lumineuses primaire et secondaire.

Ainsi, il est possible d'obtenir un seul faisceau lumineux laser en sortie du moyen de combinaison et en direction de la face d'entrée de la fibre optique.

En complément, le moyen de combinaison peut comprendre un polariseur situé entre les sources lumineuses primaire et secondaire et la face d'entrée de la fibre optique.

Ainsi il est possible d'obtenir un seul faisceau lumineux laser en sortie du polariseur.

D'autres caractéristiques et avantages de l'invention apparaitront à l'examen de la description détaillée ci-après, et des dessins annexés sur lesquels :

- La figure 1A illustre un chemin optique d'un rayon lumineux dans un dispositif lumineux;
- La figure 1B illustre un chemin optique d'un rayon lumineux dans un dispositif lumineux, et notamment la distance entre le moyen mobile de balayage et le matériau de conversion de longueur d'onde ;
- La figure 2 présente un dispositif lumineux selon un mode de réalisation de l'invention ;
- Les figures 3A, 3B et 3C illustrent le positionnement des lentilles cylindriques des moyens d'anamorphoses primaires dans un dispositif lumineux selon un mode de réalisation de l'invention ;

Les diodes lasers du fait de leur puissance peuvent nécessiter des moyens de dissipation de chaleur ou des moyens de contrôle. Or la présence des différents éléments d'un dispositif lumineux réduit l'espace disponible pour intégrer tous ces éléments. Le dispositif lumineux présente donc plusieurs contraintes :

- il est préférable que la taille du faisceau lumineux laser balayé sur le matériau photoluminescent ne dépasse pas une valeur limite, au risque d'impacter la résolution de l'image projetée ;
- la distance entre le moyen mobile de balayage et le matériau de conversion de longueur d'onde est suffisante de manière à éviter que le moyen mobile de balayage n'obstrue la sortie du matériau de conversion de longueur d'onde, par exemple 36mm ;
- la largeur du faisceau en sortie du moyen d'anamorphose ne doit pas dépasser celle du moyen mobile de balayage au risque de provoquer une perte de flux ou une possible destruction des parties fonctionnelles du moyen mobile de balayage. Or, comme énoncé précédemment la diode laser possède également des contraintes, notamment concernant l'angle de divergence du faisceau lumineux et la taille de la surface d'émission.

Comme détaillé dans ce qui suit, et selon l'invention, l'utilisation d'une fibre optique, notamment multimode, comme élément intermédiaire a pour fonction de présenter du côté du moyen mobile de balayage une sortie standardisée. La fibre optique multimode est entièrement caractérisée par la taille de son coeur et son ouverture numérique.

On entend par ouverture numérique de la fibre, un cône d'acceptance de la fibre : si un rayon lumineux tente de pénétrer la fibre en provenant de ce cône, alors le rayon est guidé par réflexion totale interne ; dans le cas contraire, le rayon n'est pas guidé.

Selon l'invention, la fibre optique a également pour fonction de permettre d'éloigner les sources laser des moyens mobiles de balayage et de l'objectif. L'utilisation d'une fibre optique peut éventuellement permettre le couplage de plusieurs sources laser.

Il est désigné ici par tache ou également « spot », l'image formée du coeur de la fibre optique à la surface d'un matériau de conversion de longueur d'onde, comme il sera mieux compris en référence à la figure 4 décrite ci-après. Les dimensions du spot étant imposées par les applications, le grandissement du système est donc imposé pour une fibre optique de diamètre de coeur donnée. Il peut également être considéré qu'inversement, le diamètre de coeur de la fibre optique est imposé pour un système optique de grandissement donné. En outre, si pour un moyen mobile de balayage donné, il est imposé que la totalité de la lumière issue de la fibre optique rencontre le moyen mobile de balayage et que la distance de celui-ci par rapport au matériau de conversion est imposée, il en est déduit qu'une relation mathématique entre le diamètre de la fibre et son ouverture numérique est imposée.

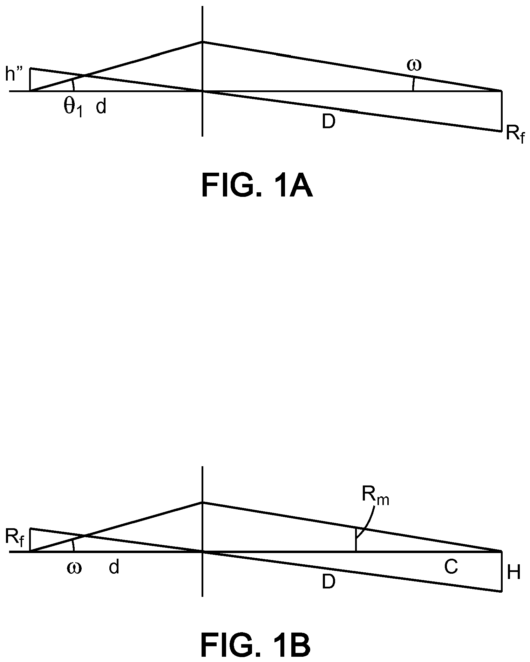

Le couplage de la source dans la fibre optique avec l'utilisation d'un moyen traditionnel, tel qu'une simple lentille convergente, biconvexe ou non, boule, etc, impose une relation entre les divergences du faisceau lumineux laser imposées par la source, les dimensions de ladite source, les dimensions du dispositif de balayage, la taille souhaitée pour le spot final et la distance des moyens de balayage aux moyens de conversion. Les figures 1A et 1B illustrent un calcul approximatif en paraxial, c'est à dire avec des angles de valeurs faibles tel que par exemple un angle de 15°, utilisant un rayon extrême issu du centre de la source et conciliant toutes les contraintes du système en utilisant la distance du moyen mobile de balayage au matériau de conversion comme variable d'ajustement. La figure 1A rappelle un calcul de base en optique géométrique. Il est désigné ici un objet de hauteur h'', plus grande dimension de la source, qui correspond en pratique au grand côté de la facette de sortie de la diode laser dont l'image par la lentille convergente a une hauteur $R_f$, rayon du coeur de la fibre optique.

Le rayon extrême issu du centre de l'objet a une incidence d'angle $\theta_1$, cet angle correspondant à l'ouverture numérique du faisceau de la diode laser. En pratique l'angle correspond au demi-angle de divergence en champ lointain suivant l'axe rapide. Ce même rayon sortant de la lentille forme un angle $\omega$ avec l'axe horizontal de la lentille, angle correspondant à l'ouverture numérique de la fibre. Un calcul géométrique permet d'obtenir la relation suivante :

$$\frac{D}{d} = \frac{R_f}{h''} = \frac{\tan(\theta_1)}{\tan(\omega)}$$

Sur la figure 1B, la grandeur c représente la distance entre :

- l'objet de hauteur $R_m$, le moyen mobile de balayage, par exemple un moyen de type « Micro-Opto-Electro-Mechanical System » (MOEMS) de diamètre $2R_m$, et
- l'image de l'objet de hauteur Rf (le coeur à la sortie de la fibre) de hauteur H (le rayon du spot ciblé, par exemple $250\mu$m).

Une application de la formule du grandissement et des relations de trigonométrie fournit les relations mathématiques suivantes :

$$\frac{R_m}{C} = \frac{d\tan(\omega)}{D} = \frac{R_f}{H}\tan(\omega) = \frac{R_f}{H}\tan(\theta_1)\frac{h''}{R_f} = \frac{h''}{H}\tan(\theta_1)$$

$$C = \frac{R_m H}{h''\tan(\theta_1)}$$

Les caractéristiques de la fibre, choisies par la personne du métier en fonction des contraintes du système, s'éliminent des formules.

Dans la pratique, il est peu fréquent que la valeur de distance obtenue de cette façon soit mécaniquement acceptable. L'application numérique pour une injection simple avec une lentille convergente unique dans le cas d'une diode laser bleue du marché pour laquelle h''= $14\mu$m et $\theta_1$=23°, un MOEMS courant de diamètre 1mm et un spot de $250\mu$m de diamètre, fournit le résultat c = 10.5mm, qui est trop petit pour l'implémentation du dispositif selon l'invention.

Afin de respecter les spécifications du système c'est-à-dire le choix de la source, de la taille du spot et du MOEMS ainsi que de pouvoir maîtriser également sa géométrie avec par exemple le choix de la distance C sans sacrifier l'efficacité optique, il est préférable d'utiliser une optique d'injection de lumière plus complexe. En effet, la création du spot par un faisceau passant par le dispositif de balayage à une distance donnée des moyens de conversion impose, comme on l'a établi précédemment, la relation mathématique suivante à la fibre optique :

$$R_f \cdot \tan(\omega) = \frac{H R_m}{C}$$

Il est généralement possible de se procurer des fibres respectant approximativement la relation ci-dessus. Cependant ces fibres ne sont en règle générale pas adaptées à l'injection de la lumière de la diode laser à l'aide d'une seule lentille convergente, du moins sans perte volontaire d'une partie du faisceau. Il est en revanche possible de la réaliser en procédant comme suit : dans le plan contenant l'axe lent de la diode laser et l'axe optique, un grandissement $g_1$ du grand côté de la surface d'émission de la source lumineuse est prévu afin de le faire correspondre, après agrandissement, au diamètre du coeur de la fibre.

Dans le plan contenant l'axe rapide de la diode laser et l'axe optique, ce plan étant perpendiculaire au précédent, il est prévu une réduction d'ouverture numérique du faisceau, qui est très divergent dans ce plan, afin de la faire correspondre à celle de la fibre optique.

Le grandissement $g_2$ qui en résulte, dans le plan précité, est bien plus grand que dans le plan précédent.

Toutefois le petit côté de la surface d'émission de la source est ici agrandi. Le petit côté de la surface d'émission de la source est en proportion, par rapport au grand côté de la surface d'émission de la source, plus petit que le rapport de grandissement $g_1/g_2$. L'image de la source sur l'entrée de la fibre optique est alors entièrement contenue dans le disque correspondant au coeur de la fibre. L'image de la source sur l'entrée de la fibre optique est alors un rectangle de rapport d'aspect différent de celui de la surface émettrice de la source. Par conséquent il est possible de nommer l'optique décrite ici comme réalisant une anamorphose.

De même dans le plan contenant l'axe lent de la source, la réduction d'ouverture numérique du faisceau est moindre que dans le plan contenant l'axe rapide, mais l'ouverture du faisceau de la source est en proportion bien plus petite suivant l'axe rapide que suivant l'axe lent, de sorte que le faisceau reste également dans ce plan et finalement en totalité à l'intérieur du cône d'acceptance de la fibre.

Pour réaliser une telle optique, il convient d'utiliser, au minimum, deux dioptres présentant des puissances optiques dans des plans perpendiculaires.

Chaque dioptre présente peu ou pas de puissance dans le plan où l'autre dioptre présente l'essentiel de sa puissance. Devant chacun des dioptres, afin de procurer des grandissements différents d'un même objet, tel que la source par exemple, dans un même plan image, telle que la face d'entrée de la fibre, ces deux dioptres sont éloignés de la source de distances différentes.

Le dioptre le plus proche de la source procure le grandissement le plus grand. Le dioptre le plus proche de la source possède donc de la puissance dans le plan contenant l'axe rapide et l'axe optique. En pratique, pour éviter l'usage d'une lentille épaisse, il est préférable d'utiliser deux lentilles distinctes.

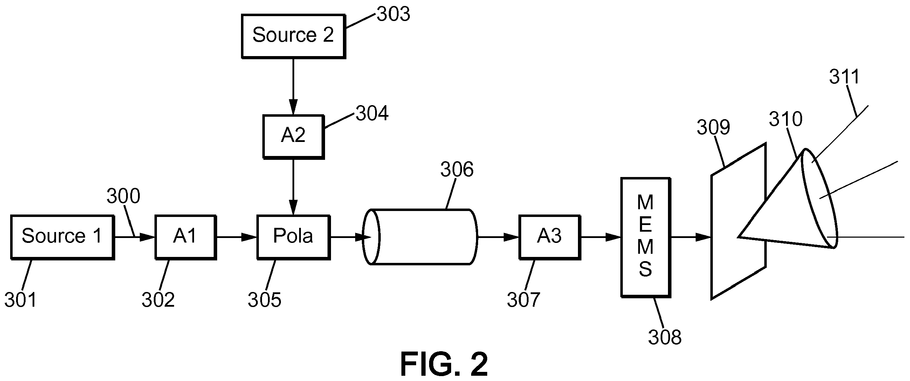

La figure 2 présente un dispositif lumineux selon un mode de réalisation de l'invention. Le dispositif comprend au moins une source lumineuse laser 301 émettant un faisceau lumineux laser 300. Le dispositif comprend également une fibre optique 306 agencée pour recevoir sur une face d'entrée le faisceau lumineux laser 300 émis par la source lumineuse laser 301 de manière à diriger ledit faisceau lumineux laser vers un moyen mobile de balayage 308.

Le moyen mobile de balayage à pilotage électronique 308 connu en anglais en tant que « MEMS », pour « microelectromechanical systems », balaye le faisceau lumineux laser reçu en direction d'un matériau de conversion de longueur d'onde 309 apte à convertir une partie d'un faisceau lumineux laser, à diffuser une autre partie du faisceau lumineux laser et à combiner les parties diffusées et converties en un faisceau lumineux résultant. Le matériau de conversion de longueur d'onde 309 réfléchit le faisceau lumineux vers un moyen optique de projection 310 du faisceau lumineux résultant, qui projette ce faisceau lumineux résultant 311 dans la scène de route devant le véhicule automobile.

L'utilisation d'une fibre optique permet de focaliser le faisceau lumineux laser sur le matériau de conversion de longueur d'onde en passant par un moyen mobile de balayage donné situé à une distance donné du dit matériau de conversion de longueur d'onde. L'introduction de la fibre optique dans le dispositif lumineux permet de répondre aux contraintes géométriques du dispositif lumineux.

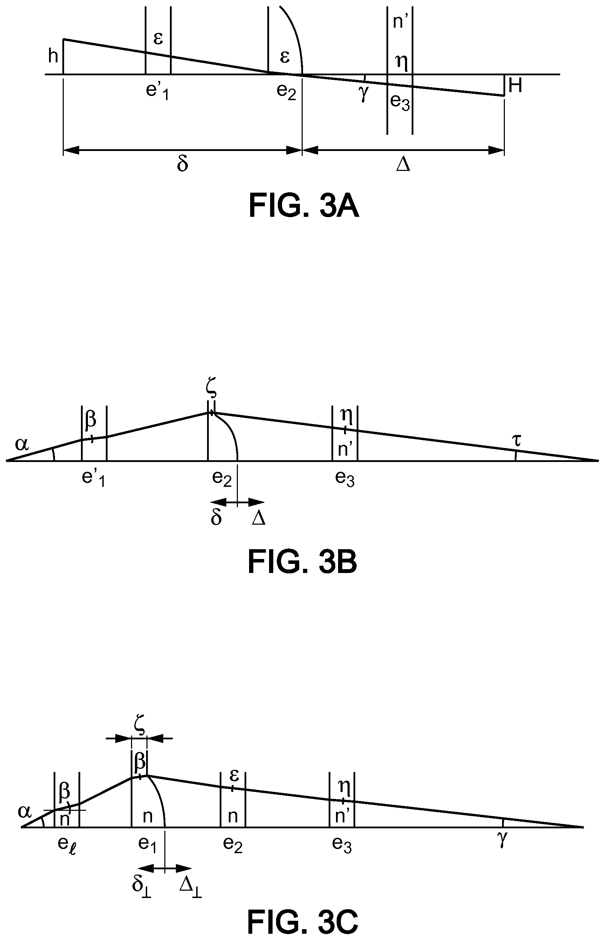

La figure 3 décrit plus particulièrement, de manière illustrative, un dispositif lumineux comprenant en outre une source lumineuse laser secondaire 303. L'utilisation d'une source lumineuse laser secondaire et d'une source lumineuse laser primaire permet d'augmenter la puissance.

Le dispositif comprend également deux moyens d'anamorphoses primaires 302 et 304 situés respectivement directement après les sources lumineuses laser primaire et secondaire. Les moyens d'anamorphose primaires comportent au moins deux lentilles. Chaque lentille est agencée pour modifier la divergence du faisceau lumineux laser 300 incident selon une direction de traitement donnée. Le but est d'obtenir un grandissement prédéterminé de la source du faisceau lumineux laser 300 incident selon la direction de traitement donnée.

Les directions de traitement des lentilles de chaque moyen d'anamorphose sont perpendiculaires entre elles et les grandissements des lentilles de chaque moyen d'anamorphose primaire sont distincts entre eux. Les lentilles comprises dans chaque moyen d'anamorphose sont par conséquent des lentilles cylindriques de génératrices de profils distincts s'étendant dans des plans perpendiculaires entre eux.

Le dispositif lumineux peut comprendre un moyen de recombinaison comportant un polariseur 305 disposé entre les première et deuxième sources lumineuses laser 301 et 303 et la face d'entrée de la fibre optique 306, notamment disposé entre les moyens d'anamorphose primaires 302 et 304 et la face d'entrée de la fibre optique 306.

Le dispositif lumineux peut comporter un moyen d'anamorphose 307 disposé entre la sortie de la fibre optique 306 et le moyen mobile de balayage 308. Le moyen d'anamorphose 307 est agencé pour modifier les divergences du faisceau lumineux laser en sortie de la fibre optique 306 selon deux directions perpendiculaires entre elles de sorte à obtenir des grandissements différents selon ces deux directions. L'utilisation de la fibre optique 306 permet de manière avantageuse d'utiliser une focalisation simple avec une seule lentille convergente en sortie de la fibre optique 306.

Le moyen mobile de balayage 308 et le dispositif optique de projection 310 sont situés de part et d'autre du matériau de conversion 309. Le matériau de conversion 309 peut également, de manière préférentielle, être déposé sur un substrat réfléchissant. Un faisceau lumineux laser résultant 311 destiné à être projeté sur route est issu du dispositif de projection 310.

Les faisceaux lumineux laser issus des sources laser 301 et 303 traversent respectivement les moyens d'anamorphose 302 et 304. Les sources lumineuses laser 301 et 303 sont agencées pour émettre des faisceaux lumineux de type laser polarisés dans deux plans perpendiculaires entre eux.

Sur la figure 3, les sources lumineuses laser sont par exemple disposées pour que leurs faces d'émission s'étendent dans des plans perpendiculaires entre eux et soient tournées l'une par rapport à l'autre de 90°. Si les deux moyens d'anamorphoses 302 et 304 sont identiques, ils sont préférentiellement agencés de manière à être tournés de 90° l'un par rapport à l'autre, excepté dans le cas de l'utilisation d'une lame demi-onde. Les faisceaux lumineux laser issus des moyens d'anamorphose 302 et 304 traversent un moyen de recombinaison de faisceau comprenant un polariseur 305. Le faisceau lumineux laser résultant issu du polariseur 305 se dirige ensuite vers la face d'entrée de la fibre optique 306.

En sortie de la fibre optique 306, le faisceau lumineux traverse un autre moyen d'anamorphose 307 situé avant le moyen mobile de balayage 308. Le moyen mobile de balayage 308 comportant plusieurs micro-miroirs mobiles reçoit le faisceau lumineux laser en provenance de la face de sortie de la fibre optique 306 et du moyen d'anamorphose 307 et le répartit spatialement sur la surface du matériau de conversion de longueur d'onde 309. Par conséquent, l'éclairement de la surface du matériau de conversion de longueur d'onde 309 est obtenu par balayage du faisceau lumineux laser issu de l'ensemble comprenant la fibre optique 306 et le moyen d'anamorphose 307.

La surface du matériau de conversion de longueur d'onde 309 peut comprendre des luminophores qui peuvent être déposés sur un substrat réfléchissant pour le faisceau lumineux laser. La surface du matériau de conversion 309 peut être constituée d'une couche continue et homogène de luminophores. Le faisceau lumineux laser sortant est ensuite dirigé vers un dispositif de projection 310 qui produit un faisceau lumineux laser résultant 311 pour un éclairage remplissant une fonction lumineuse donnée.

Les figures 3A et 3B illustrent un calcul géométrique des positions des lentilles cylindriques des moyens d'anamorphoses primaires en fonction des épaisseurs de matière des différents éléments du dispositif : lame de protection de la source, lentilles et beam splitter polarisant.

Sur la figure 3A, dans le plan de l'axe lent, h représente la hauteur d'un objet et H la hauteur de l'image de cet objet par la seconde lentille cylindrique. Les grandeurs $e_{1'}$, $e_2$ et $e_3$ représentent les épaisseurs respectives de la lame de protection de la source lumineuse laser plus l'épaisseur au centre de la première lentille, la lentille cylindrique et le beam splitter polarisant. La lame de protection de la source et les lentilles sont par exemple réalisées dans des matériaux de même indice de réfraction n. L'indice de réfraction n' correspond à l'indice de réfraction du matériau du beam splitter polarisant.

Les distances $\delta$ et $\Delta$ représentent respectivement la distance entre l'objet et la lentille cylindrique et la distance entre la lentille cylindrique et l'image de l'objet. Les angles $\varepsilon$, $\gamma$ et $\eta$ correspondent à l'angle avec l'axe optique du rayon lumineux laser considéré respectivement dans la lame de protection de la source et les lentilles, dans l'air et dans le PBS. Le rayon considéré dans ce calcul passe par l'intersection de la face de sortie de la seconde lentille et de l'axe optique.

Le calcul géométrique fournit les égalités suivantes :

$$H = (\Delta - e_3)\tan(\gamma) + e_3\tan(\eta)$$

$$h = (\delta - e_1' - e_2)\tan(\gamma) + (e_1 + e_2)\tan(\varepsilon)$$

En posant $g = \dfrac{H}{h}$ et en considérant que l'angle $\gamma$ tend vers 0 pour obtenir la valeur paraxiale du grandissement, g tend alors d'après les lois d'optique géométrique vers

$$\frac{(\Delta - e_3) + \dfrac{e_3}{n'}}{\delta - (e_1' + e_2) + \dfrac{e_1' + e_2}{n}}$$

Il en est déduit l'égalité suivante :

$$\Delta = g\left(\delta - (e_1' + e_2)\frac{n-1}{n} + e_3\frac{n'-1}{n'}\right)$$

en considérant la valeur de paraxiale de g, connue par ailleurs. En effet, la valeur de g est égale au rapport du diamètre du coeur de la fibre optique à la longueur du grand côté de la surface éclairant de la source laser.

Pour un encombrement total $\delta+\Delta$ donné, de la source à l'entrée de la fibre optique, on en déduit $\delta$ et $\Delta$.

Sur la figure 3B, dans le même plan que celui de la figure 3A, un rayon, issu du centre de la source incliné d'un angle $\alpha$ par rapport à l'axe optique, est propagé. La grandeur $\zeta$ représente la distance en projection sur l'axe optique parcourue par le rayon dans la seconde lentille. L'angle r représente l'angle entre le rayon lumineux issue du beam splitter polarisant et l'horizontale.

Le calcul géométrique ainsi que les lois d'optique géométrique fournissent les égalités suivantes :

$$(\delta - e_1' - e_2)\tan(\alpha) + (e_1' + \zeta)\tan(\beta) = (\Delta - e_3 + (e_2 - \zeta))\tan(r) + e_3\tan(\eta)$$

$$\frac{\delta - e_1' - e_2}{\cos(\alpha)} + n\frac{e_1' + \zeta}{\cos(\beta)} + \frac{\Delta - e_3 + e_2 - \zeta}{\cos(r)} + n'\frac{e_3}{\cos(\eta)} = \delta + \Delta - e_1' - e_2 - e_3 +$$
$$n(e_1' + e_2) + n'e_3$$

d'après le théorème de Fermât,
et d'après les lois de Descartes :

$$n.\sin(\beta) = \sin(\alpha) \; ; \; n'\sin(\eta) = \sin(\tau)$$

Il est possible d'éliminer les grandeurs $\beta$, $\eta$ et $\alpha$ entre les équations ci-dessus, de manière à obtenir une équation en $\zeta$, fonction de $\tau$. La fonction $\zeta(\tau)$ solution numérique de cette équation permet alors de construire la section droite de la seconde lentille cylindrique, qui est ainsi entièrement définie à partir des grandeurs géométriques et physiques de conception du dispositif.

La figure 3C correspond au plan de l'axe rapide et de l'axe optique, ce plan est perpendiculaire au plan des figures 3A et 3B. La lentille est acylindrique d'épaisseur $e_1$. La lame de protection de la source lumineuse laser a une épaisseur $e_1$. Le faisceau incident d'angle $\alpha$ a un angle $\beta$ à l'intérieur de la lame de protection de la source lumineuse laser. La grandeur $\zeta$ représente la distance en projection sur l'axe optique parcourue par le rayon dans la seconde lentille. La seconde lentille d'épaisseur $e_2$ dévie le faisceau d'un angle $\varepsilon$. L'angle $\gamma$ représente l'angle entre le rayon lumineux issu du beam splitter polarisant et l'horizontale.

Le calcul géométrique ainsi que les lois d'optique géométrique fournissent les égalités suivantes :

$$\delta + \Delta = \delta_\perp + \Delta_\perp$$

$$(\delta_\perp - e_1 - e_l)\tan(\alpha) + (e_l + \zeta)\tan(\beta)$$
$$= (\Delta_\perp - e_2 - e_3 + (e_1 - \zeta))\tan(\gamma) + e_2\tan(\varepsilon) + e_3\tan(\eta)$$

$$\frac{(\delta_\perp - e_1 - e_l)}{\cos(\alpha)} + n\frac{e_l}{\cos(\beta)} + n\frac{\zeta}{\cos(\beta)} + \frac{\Delta_\perp - e_2 - e_3 + e_1 - \zeta}{\cos(\gamma)} + n\frac{e_2}{\cos(\varepsilon)} + n'\frac{e_3}{\cos(\eta)}$$

$$= \delta_\perp - e_1 - e_l + n(e_1 + e_l) +$$
$$\Delta_\perp - e_2 - e_3 + ne_2 + n'e_3 = \delta + \Delta + (n-1)(e_l + e_1 + e_2) + (n'-1)l$$

d'après le théorème de Fermât ;
et d'après les lois de Descartes :

$$n.\sin(\beta) = \sin(\alpha) \; ; \; n'\sin(\eta) = \sin(y) \; ; \; n.\sin(\varepsilon) = \sin(\gamma)$$

En éliminant des équations ci-dessus $\beta$, $\eta$, $\varepsilon$, $\zeta$ et $\Delta_\perp$, une équation en $\gamma$ fonction de $\alpha$ et de $\delta_\perp$ est obtenue. Il est imposé, pour a, demi angle au sommet du faisceau de la source dans le plan de l'axe rapide, $\gamma = \omega$ avec $\omega$ demi angle au sommet correspondant à l'ouverture numérique de la fibre optique. Cela peut se traduire par le fait que l'ensemble du faisceau entre dans la fibre optique. Il en est déduit $\delta_\perp$ et par conséquent $\Delta_\perp$.

En reprenant les six équations ci-dessus et en éliminant $\alpha$, $\beta$, $\eta$ $\varepsilon$ une équation en $\zeta$, fonction de $\gamma$ est obtenue. La fonction $\zeta(\gamma)$ solution numérique de cette équation permet alors de construire la section droite de la première lentille cylindrique, qui est ainsi entièrement définie à partir des grandeurs géométriques et physiques de conception.

Par conséquent, ayant obtenu comme indiqué ci-dessus les valeurs de écarts $\delta_\perp$ et $\Delta_\perp$, il est également prévu par l'invention, au lieu de calculer ces valeurs analytiquement, de modéliser les sections droites des lentilles cylindriques par des fonctions polynomiales de degré suffisamment élevé par exemple de degré 8 et en faire calculer les paramètres par un logiciel d'optimisation.

Si des lentilles calculées comme décrit précédemment permettent effectivement une bonne injection de la lumière des sources dans la fibre optique, il convient de remarquer que les rayons fortement écartés des plans de calcul, notamment les rayons issus des sources à des valeurs proches des valeurs extrêmes de divergence, à la fois dans le plan de l'axe rapide et dans le plan de l'axe lent, ne suivent pas exactement les trajets prévus, le système a des aberrations notables dans les coins du champ. Ce problème peut être corrigé si cela s'avère nécessaire, dans le cas de la perte d'un nombre important de rayons , soit en modifiant une des faces planes des lentilles cylindriques en une surface biconique ou polynomiale avec des termes croisés, par exemple de la forme $X^k Y^t$, soit en rejetant les sources du calcul à l'infini vers l'arrière en plaçant les sources réelles aux foyers de lentilles de collimation. Chaque anamorphoseur comprend alors trois lentilles : une lentille de collimation et deux lentilles cylindriques ; cette solution plus coûteuse peut néanmoins être justifiée dans le cas de productions de petite séries afin d'éviter l'investissement du moule complexe de la lentille cylindrique à face d'entrée modifiée.

Ainsi, l'utilisation d'une fibre optique permet de découpler les contraintes qui s'appliquent d'une part à la source, et d'autre part, à la partie du dispositif comprenant le moyen mobile de balayage et le moyen de conversion. Il est ainsi plus aisé de respecter des contraintes géométriques prédéfinies, telles que les contraintes optiques présentées dans les calculs ci-dessus.

Bien entendu, l'invention n'est pas limitée aux modes de réalisation décrits précédemment et fournis uniquement à titre d'exemple. Elle englobe diverses modifications, formes alternatives et autres variantes que pourra envisager l'homme du métier dans le cadre de la présente invention et notamment toutes combinaisons des différents modes de réalisation décrits précédemment.

## Revendications

1. Dispositif lumineux, notamment pour véhicule automobile comprenant :

   - au moins une source lumineuse (301) laser émettant un faisceau lumineux laser (300);
   - un matériau de conversion de longueur d'onde (309) apte à convertir une partie d'un faisceau lumineux laser, à diffuser une autre partie du faisceau lumineux laser et à combiner les parties diffusée et convertie en un faisceau lumineux primaire résultant ;
   - un moyen mobile de balayage (308) du faisceau lumineux laser sur le matériau de conversion de longueur d'onde (309) ;
   - un moyen optique de projection (310) du faisceau lumineux primaire ;
   - une fibre optique (306) agencée pour recevoir sur une face d'entrée le faisceau lumineux laser émis par la source lumineuse laser et pour diriger ledit faisceau lumineux laser vers le moyen mobile de balayage.

2. Dispositif lumineux selon la revendication précédente, dans lequel la fibre optique (306) est définie par au moins un diamètre de coeur et une ouverture numérique, et dans lequel, le diamètre de coeur, l'ouverture numérique et l'agencement de la fibre optique relativement au moyen mobile de balayage (308) soient tels que le faisceau balayé forme une tâche d'au plus 300 micromètres sur le moyen de conversion (309).

3. Dispositif lumineux selon la revendication 2, dans lequel le diamètre de coeur, l'ouverture numérique et l'agencement de la fibre optique (306) relativement au moyen mobile de balayage (308) sont tels que le faisceau balayé forme une tâche d'au plus 250 micromètres sur le moyen de conversion (309).

4. Dispositif lumineux selon l'une des revendications précédentes, comprenant un moyen de focalisation ou un moyen d'anamorphose (307) disposé entre la sortie de la fibre optique (306) et le moyen mobile de balayage (308).

5. Dispositif lumineux selon l'une des revendications précédentes comportant un moyen d'anamorphose primaire (302) disposé entre chaque source lumineuse et la face d'entrée de la fibre optique (306).

**6.** Dispositif lumineux selon la revendication 5, dans lequel le moyen d'anamorphose primaire (302) est agencé de manière à former une image du faisceau lumineux émis, sur la fibre optique (306), ladite image ayant des dimensions inférieures ou égales à la face d'entrée de la fibre optique (306) et l'ouverture numérique du faisceau incident étant inférieure ou égale à celle de la fibre optique.

**7.** Dispositif lumineux selon la revendication 5 ou 6, dans lequel le moyen d'anamorphose primaire (302) comprend au moins deux lentilles.

**8.** Dispositif lumineux selon la revendication 7, dans lequel chaque lentille est agencée de manière à modifier la divergence d'un faisceau incident selon une direction de traitement donnée pour obtenir un grandissement prédéterminé selon la direction de traitement donnée.

**9.** Dispositif lumineux selon la revendication 18, dans lequel les directions de traitement des lentilles du moyen d'anamorphose (302) sont perpendiculaires entre elles.

**10.** Dispositif lumineux selon la revendication 9, dans lequel les grandissements des lentilles du moyen d'anamorphose primaire (302) sont distincts.

**11.** Dispositif lumineux selon la revendication 9 ou 10, dans lequel les lentilles du moyen d'anamorphose primaire (302) sont des lentilles cylindriques ayant des génératrices respectives s'étendant dans des plans perpendiculaires entre eux.

**12.** Dispositif lumineux selon l'une des revendications précédentes, comprenant une source lumineuse primaire (301) émettant un premier faisceau lumineux et une source lumineuse secondaire (303) émettant un second faisceau lumineux, dans lequel la fibre optique (306) est agencée pour recevoir sur la face d'entrée les premier et second faisceaux lumineux laser de manière à diriger lesdits premier et second faisceaux lumineux laser vers le moyen mobile de balayage (308).

**13.** Dispositif lumineux selon la revendication 1, dans lequel les sources lumineuses primaire (301) et secondaire (303) sont agencées de manière à émettre des faisceaux lumineux laser polarisés dans des plans respectifs perpendiculaires entre eux.

**14.** Dispositif lumineux selon la revendication 12 ou 13, comportant un moyen de combinaison (305) apte à polariser les faisceaux laser en provenance des sources lumineuses primaire (301) et secondaire (303).

**15.** Dispositif lumineux selon la revendication 14, dans lequel le moyen de combinaison (305) comprend un polariseur situé entre les sources lumineuses primaire (301) et secondaire (303) et la face d'entrée de la fibre optique (306).

**FIG. 1A**

**FIG. 1B**

FIG. 2

EP 3 376 613 A1

FIG. 3A

FIG. 3B

FIG. 3C

Europäisches
Patentamt

European
Patent Office

Office européen
des brevets

## RAPPORT DE RECHERCHE EUROPEENNE

Numéro de la demande

EP 18 16 0238

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2016/018075 A1 (OHNO MASAFUMI [JP]) 21 janvier 2016 (2016-01-21) | 1,4,7-15 | INV. H01S5/00 |
| Y | * alinéas [0065] - [0075], [0116]; figure 7 * | 2,3,5,6 | F21S41/64 |
| | ----- | | ADD. |
| Y | US 2013/258689 A1 (TAKAHIRA YOSHIYUKI [JP] ET AL) 3 octobre 2013 (2013-10-03) | 2,3,5,6 | F21V14/04 |
| A | * alinéas [0380], [0408] - [0410]; figures 21,29 * | 1,4,7-15 | |
| | ----- | | |

| DOMAINES TECHNIQUES RECHERCHES (IPC) |
|---|
| H01S F21V F21S G02B |

Le présent rapport a été établi pour toutes les revendications

| Lieu de la recherche | Date d'achèvement de la recherche | Examinateur |
|---|---|---|
| Munich | 20 juillet 2018 | Cortona, Anna |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 18 16 0238

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-07-2018

| Document brevet cité au rapport de recherche | Date de publication | Membre(s) de la famille de brevet(s) | Date de publication |
|---|---|---|---|
| US 2016018075 A1 | 21-01-2016 | EP 2975318 A1<br>JP 6354116 B2<br>JP 2016024929 A<br>US 2016018075 A1 | 20-01-2016<br>11-07-2018<br>08-02-2016<br>21-01-2016 |
| US 2013258689 A1 | 03-10-2013 | AUCUN | |

EPO FORM P0460

Pour tout renseignement concernant cette annexe : voir Journal Officiel de l'Office européen des brevets, No.12/82